# DEMANDE DE BREVET EUROPEEN

(11) **EP 4 187 579 A1**
(43) Date de publication de la demande: **31.05.2023**
(21) Numéro de dépôt: 22208221.6
(22) Date de dépôt: 18.11.2022
(51) Int. Cl.: H01L 21/66, H01L 23/485

(54) **STRUCTURE ET PROCÉDÉ DE TEST ET DE TRANSFERT D'UN DISPOSITIF OPTOÉLECTRONIQUE**

(30) Priorité: 24.11.2021 FR 2112443
(71) Demandeur: Aledia, 38130 Echirolles (FR)
(72) Inventeur: MAYER, Frédéric, 38430 MOIRANS (FR)
(74) Mandataire: Hautier IP

(57) **Abrégé**

L'invention a pour objet une structure (2) de test et de transfert de plots de contact (223) comprenant une partie de test (21), et une partie de contact (22), la partie de test (21) comprenant au moins un réseau d'interconnexions électriques (211, 213), la partie de contact (22) comprenant au moins un plot de contact (223) au niveau d'une face de contact (200), ledit au moins un plot de contact étant destiné à être mis en contact avec au moins une zone de contact (123) au niveau d'une face de connexion (100) d'un dispositif électronique (1), la structure étant caractérisée en ce que la partie de contact (22) comprend en outre au moins une portion (225) sacrificielle électriquement conductrice reliant électriquement l'au moins un plot de contact (223) au réseau d'interconnexions électriques (211, 213).

L'invention a également pour objet un procédé de test et de transfert mettant en œuvre une telle structure (2).

## Description

### DOMAINE TECHNIQUE

La présente invention concerne le domaine des technologies pour la microélectronique et l'optoélectronique notamment. Elle trouve pour application particulièrement avantageuse le test et la fabrication de systèmes microélectroniques ou optoélectroniques par transfert en masse de dispositifs unitaires, par exemple des diodes électroluminescentes à base de GaN.

### ETAT DE LA TECHNIQUE

Un écran d'affichage auto-émissif est un exemple de système optoélectronique connu. Un tel écran comprend une pluralité de pixels émettant leur propre lumière. Chaque pixel est ainsi typiquement formé par une ou plusieurs LEDs ou micro-LEDs. Chaque LED est un dispositif optoélectronique unitaire.

Ces dispositifs optoélectroniques unitaires sont typiquement formés de manière collective sur un substrat donneur, puis individualisés - c'est-à-dire séparés les uns des autres - avant d'être transférés vers un substrat receveur. Le transfert peut être effectué de façon collective, ou encore selon un principe dit « pick and place » selon la terminologie anglo-saxonne usuelle.

Cependant, il arrive que certains dispositifs optoélectroniques unitaires ne présentent pas des performances optimales. Par exemple, des défauts apparus lors de la fabrication de ces dispositifs peuvent rendre certains dispositifs non fonctionnels. Pour éviter de transférer ces dispositifs non fonctionnels lors des étapes de transfert collectif ou de transfert « pick and place », une détection préalable des dispositifs non fonctionnels est souhaitable. Une telle étape de détection préalable permet de limiter les coûts de réparation ultérieurs, lors de la fabrication du système optoélectronique. Cette stratégie de détection et de tri est classiquement appelée « Known Good Die » ou « KGD ».

Comme les dispositifs unitaires sont généralement individualisés, il est difficile de détecter les dispositifs anormaux aisément. Cette détection implique notamment d'alimenter électriquement et/ou d'envoyer un signal électrique de test à chaque dispositif individuellement, et d'étudier son comportement lorsqu'il est alimenté/testé.

Le document WO2021094177 divulgue une solution consistant à former un contact de test commun à tous les dispositifs unitaires, au début du procédé de fabrication desdits dispositifs. Dans cette solution, le test des dispositifs est réalisé très tôt dans le procédé de fabrication. Cela empêche de détecter des problèmes survenant plus tard lors de la fabrication. Il se peut que des dispositifs ayant été testés avec succès ne soient finalement pas fonctionnels lors du transfert vers le substrat receveur. Par ailleurs, cette solution nécessite des étapes supplémentaires pour former le contact de test. Ces étapes doivent en outre être développées spécifiquement en fonction du design de chaque pixel.

Une autre solution connue consiste à effectuer un test capacitif des dispositifs optoélectroniques unitaires. Là encore, il est difficile de détecter précisément et individuellement les dispositifs défectueux.

La présente invention vise à pallier au moins partiellement les inconvénients des solutions mentionnées ci-dessus.

En particulier, un objet de la présente invention est de proposer une structure de test et de transfert permettant de tester individuellement un dispositif électronique parmi une pluralité de dispositifs électroniques unitaires. Un autre objet de la présente invention est de proposer un procédé de test et de transfert de dispositifs électroniques.

Les autres objets, caractéristiques et avantages de la présente invention apparaîtront à l'examen de la description suivante et des dessins d'accompagnement. Il est entendu que d'autres avantages peuvent être incorporés. En particulier, certaines caractéristiques et certains avantages du procédé de test et/ou de transfert peuvent s'appliquer *mutatis mutandis* à la structure ou au système de test et/ou de transfert, et réciproquement.

### RESUME

Pour atteindre les objectifs mentionnés ci-dessus, un aspect concerne une structure de test et de transfert de plots de contact destinée à tester au moins un dispositif électronique et à transférer au moins un plot de contact sur ledit au moins un dispositif électronique.

Avantageusement, la structure comprend une partie de test, et une partie de contact. La partie de test comprend au moins un réseau d'interconnexions électriques.

La partie de contact comprend au moins un plot de contact au niveau d'une face de contact, ledit au moins un plot de contact étant destiné à être mis en contact avec au moins une zone de contact au niveau d'une face de connexion du dispositif électronique.

Avantageusement, la partie de contact comprend en outre au moins une portion sacrificielle électriquement conductrice, reliant électriquement l'au moins un plot de contact au réseau d'interconnexions électriques de la partie de test. L'au moins une portion sacrificielle est apte à être gravée pour permettre de libérer, au moins partiellement, l'au moins un plot de contact. En particulier, après gravure de la portion sacrificielle, le plot de contact est libre vis-à-vis de la partie de test. Il n'est plus relié directement à la partie de test.

La portion sacrificielle est ainsi typiquement configurée de façon à libérer l'au moins un plot de contact après que celui-ci ait été mis en contact avec l'au moins une zone de contact du dispositif électronique. Cette portion sacrificielle permet de réaliser une liaison électrique entre le réseau d'interconnexions électriques de la partie de test et l'au moins un plot de contact destiné à venir au contact du dispositif électronique. Ainsi, la structure de test et de transfert permet typiquement d'effectuer un test électrique d'un dispositif électronique, par mise en contact de l'au moins un plot de contact avec la zone de contact dudit dispositif électronique, puis d'effectuer un transfert de ce plot de contact sur ledit dispositif électronique, par exemple en retirant la portion sacrificielle électriquement conductrice sélectivement au plot de contact.

Une telle structure permet avantageusement de réaliser deux opérations technologiques, à savoir le test électrique d'un dispositif électronique et le transfert d'un plot de contact sur un dispositif électronique, de façon efficace. Ces deux opérations technologiques peuvent être dissociées. La structure de test et de transfert peut ainsi être utilisée uniquement pour effectuer un test électrique d'un dispositif électronique ou pour effectuer uniquement un transfert de plot de contact sur un dispositif électronique, ou pour effectuer un test électrique et un transfert de plot de contact sur un dispositif électronique.

Une telle structure de test et de transfert peut donc être avantageusement utilisée de façon versatile pour le test et/ou le transfert de plot de contact.

Le test électrique du dispositif électronique peut en outre être réalisé préalablement au report de ce dispositif électronique sur un substrat receveur, à la fin du procédé de fabrication de ce dispositif électronique sur le substrat donneur. Ainsi, la capacité à détecter des défauts survenus tardivement lors de la fabrication des dispositifs électroniques est significativement améliorée.

L'au moins un plot de contact intégré à la structure de test et de transfert est en outre facilement transférable au dispositif électronique. Cela simplifie la conception et le design des dispositifs électroniques. De façon avantageuse, la structure de test et de transfert prévoit au moins un plot de contact pour chaque dispositif électronique à tester. Cela permet de tester individuellement les dispositifs électroniques.

Un autre aspect concerne un système comprenant une telle structure de test et de transfert comprenant une pluralité de plots de contact, le système comprenant en outre une pluralité de dispositifs électroniques présentant chacun une face de connexion et comprenant chacun au moins une zone de contact. Les plots de contact de la structure de test et de transfert sont avantageusement configurés pour être assemblés aux zones de contact des dispositifs électroniques.

Dans ce système, la structure de test et de transfert permet de tester individuellement chacun des dispositifs et/ou de transférer collectivement des plots de contact aux dispositifs électroniques.

Un autre aspect concerne un procédé de test et de transfert d'au moins un plot de contact, destiné à tester au moins un dispositif électronique, et à transférer au moins un plot de contact depuis une structure de test et de transfert telle que décrite ci-dessus, sur ledit au moins un dispositif électronique.

Avantageusement, le procédé comprend au moins les étapes suivantes :
- fournir l'au moins un dispositif électronique, ledit au moins un dispositif électronique présentant une face de connexion comprenant au moins une zone de contact,
- aligner l'au moins un plot de contact de la structure de test avec l'au moins une zone de contact du dispositif électronique,
- assembler la structure de test au dispositif électronique,
- retirer l'au moins une portion sacrificielle électriquement conductrice, sélectivement à l'au moins un plot de contact, puis
- désolidariser la structure de test du dispositif électronique, en laissant l'au moins un plot de contact sur l'au moins une zone de contact du dispositif électronique.

Ainsi, le retrait sélectif, par gravure typiquement, de l'au moins une portion sacrificielle permet de faciliter le détachement du dispositif électronique de la structure de test. Le procédé permet avantageusement de transférer au moins un plot de contact sur au moins une zone de contact d'un dispositif électronique. De préférence, le procédé comprend en outre, après assemblage de la structure de test à l'au moins un dispositif électronique, et avant retrait de l'au moins une portion sacrificielle électriquement conductrice, une étape de test du dispositif électronique prise parmi un test électrique ou un test de fonctionnement, ladite étape de test étant effectuée via la partie de test de la structure de test et de transfert.

Les dispositifs électroniques peuvent comprendre au moins une diode électroluminescente (LED). Les dispositifs électroniques peuvent également comprendre au moins un circuit électronique de commande dédié au pilotage de ladite diode électroluminescente. Les dispositifs électroniques forment dès lors des « smart » LEDs, selon la terminologie anglo-saxonne usuelle.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1 illustre schématiquement un dispositif optoélectronique de type smart LED.
Les figures 2 à 6 illustrent schématiquement des étapes d'un procédé de test et de transfert selon un mode de réalisation de la présente invention.
Les figures 7 à 12 illustrent schématiquement des étapes de fabrication d'une structure de test et de transfert selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions des différentes parties des structures de test et de transfert et des LED ne sont pas forcément représentatives de la réalité.

### DESCRIPTION DÉTAILLÉE

Avant d'entamer une revue détaillée de modes de réalisation de l'invention, il est rappelé que l'invention selon son premier aspect comprend notamment les caractéristiques optionnelles ci-après pouvant être utilisées en association ou alternativement :
Selon un exemple, la partie de contact comprend une couche de collage au niveau de la face de contact, en bordure de l'au moins un plot de contact, de sorte que la face de contact soit formée par une surface du plot de contact et une surface de la couche de collage. Cela permet d'améliorer la mise en contact de la structure de test et de transfert avec le dispositif électronique. Le dispositif électronique peut ainsi être assemblé à la structure de test et de transfert par adhésion au niveau de la surface de la couche de collage. Indépendamment ou en combinaison, le plot de contact de la structure de test et de transfert peut être assemblé à la zone de contact du dispositif électronique. Le collage est de préférence effectué par collage direct, par exemple selon un collage hydrophile assisté par Plasma, ou selon un collage sous ultra-vide de type SAB, pour « Surface Activated Bonding », ou encore par thermocompression.

Selon un exemple, l'au moins une portion sacrificielle forme un premier moyen d'attachement direct entre l'au moins un plot de contact et la partie de test, ladite structure comprenant en outre un deuxième moyen d'attachement indirect entre l'au moins un plot de contact et la partie de test, de sorte que, lorsque l'au moins une portion sacrificielle est retirée sélectivement au deuxième moyen d'attachement, l'au moins un plot de contact reste solidaire de la partie de test par l'intermédiaire dudit deuxième moyen d'attachement. Ainsi, le dispositif électronique reste solidaire de la partie de test après retrait de l'au moins une portion sacrificielle formant le premier moyen d'attachement. Selon un exemple, le deuxième moyen d'attachement est formé par une tranchée d'isolation à base de matériau diélectrique. Le deuxième moyen d'attachement est à base d'un matériau différent de celui de l'au moins une portion sacrificielle.

Selon un exemple, l'au moins un plot de contact comprend une première couche à base d'un matériau pris parmi Au, Sn, SnAg ou SnAgCu, de préférence une couche intercalaire de Ni, et une deuxième couche de Cu en empilement selon une direction z perpendiculaire à la face de contact, la deuxième couche de Cu étant située du côté de la face de contact, et la première couche étant située du côté opposé, en regard de la partie de test. L'empilement de couches métalliques du contact est ainsi typiquement inversé par rapport à celui d'un contact standard. Cela permet de former ensuite un contact présentant un empilement de couches métalliques standard, après report dudit contact sur le dispositif électronique.

Selon un exemple, la portion sacrificielle électriquement conductrice borde l'au moins un plot de contact sur un côté opposé à la face de contact et en partie sur des flancs latéraux de l'au moins un plot de contact. Cela permet de minimiser la résistance électrique entre la portion sacrificielle et le plot de contact. Cela permet en outre, après retrait de la portion sacrificielle, de dégager une majeure partie du plot de contact.

Selon un exemple, la portion sacrificielle électriquement conductrice est en silicium polycristallin dopé n++. Ce matériau présente une bonne conductivité électrique. Il peut en outre être facilement gravé, par exemple par un procédé de gravure sèche à base de XeF2. Selon un exemple alternatif, la portion sacrificielle électriquement conductrice est en silicium polycristallin dopé p.

Selon un exemple, la partie de contact comprend au moins une première portion sacrificielle électriquement conductrice et une deuxième portion sacrificielle électriquement conductrice, et au moins une tranchée d'isolation à base de matériau diélectrique configurée pour isoler entre elles lesdites première et deuxième portions sacrificielles électriquement conductrices. La structure de test et de transfert permet ainsi de contacter indépendamment deux dispositifs électroniques ou deux zones de contacts distinctes d'un même dispositif électronique.

Selon un exemple, la partie de test comprend un circuit électronique intégré relié au réseau d'interconnexions électriques et configuré pour communiquer avec le dispositif électronique. La partie de test permet ainsi de réaliser des séquences de test plus complexes qu'un simple test de continuité électrique. Des tests fonctionnels du dispositif sont ainsi possibles.

Selon un exemple, les dispositifs électroniques sont des diodes électroluminescentes ou des diodes électroluminescentes comprenant chacune une électronique de pilotage intégrée.

Selon un exemple, la portion sacrificielle électriquement conductrice est à base de polySi n++ et le retrait est effectué par une solution de gravure à base de XeF2. Une telle solution de gravure peut-être avantageusement sélective vis-à-vis des métaux formant le plot de contact et/ou du matériau diélectrique formant la tranchée d'isolation. Ainsi, seule la portion sacrificielle est retirée lors de l'étape de retrait.

Selon un exemple, l'au moins un dispositif électronique comprend un premier dispositif électronique et un deuxième dispositif électronique solidaires l'un de l'autre et comprenant des faces de connexion dans un même plan, le procédé comprenant en outre, après assemblage de la structure de test auxdits premier et deuxième dispositifs électroniques, et avant retrait de l'au moins une portion sacrificielle électriquement conductrice, une étape d'individualisation configurée pour séparer les premier et deuxième dispositifs électroniques par une tranchée de séparation débouchant dans l'au moins une portion sacrificielle électriquement conductrice. La tranchée de séparation permet d'individualiser les dispositifs électroniques entre eux. La tranchée de séparation permet en outre de faciliter l'accès aux portions sacrificielles, typiquement lors du retrait desdites portions sacrificielles.

Selon un exemple, la partie de contact de la structure de test comprend au moins une première portion sacrificielle électriquement conductrice et une deuxième portion sacrificielle électriquement conductrice, et au moins une tranchée d'isolation à base de matériau diélectrique configurée pour isoler entre elles lesdites première et deuxième portions sacrificielles électriquement conductrices, ladite au moins une tranchée d'isolation maintenant l'au moins un dispositif électronique sur la structure de test après retrait desdites première et deuxième portions sacrificielles électriquement conductrices. La tranchée d'isolation permet non seulement d'isoler électriquement les portions sacrificielles entre elles, mais également de former un élément structurel de support du dispositif lors du retrait des portions sacrificielles.

Selon un exemple, la désolidarisation de l'au moins un dispositif électronique est effectuée en fixant un tampon sur une face de l'au moins un dispositif électronique opposée à la face de connexion, et en exerçant une traction mécanique de sorte à rompre ladite au moins une tranchée d'isolation. La ou les tranchées d'isolation forment un support du dispositif qui peut être facilement rompu en exerçant une traction mécanique sur le dispositif. Le désassemblage du dispositif et de la partie de test de la structure de test et de transfert est facilité.

Selon un exemple, le procédé comprend en outre, si l'au moins un dispositif électronique est repéré comme étant défectueux après l'étape de test, une étape d'élimination de ce dispositif défectueux, par exemple par écrasement après retrait de l'au moins une portion sacrificielle électriquement conductrice.

Sauf incompatibilité, des caractéristiques techniques décrites en détail pour un mode de réalisation donné peuvent être combinées aux caractéristiques techniques décrites dans le contexte d'autres modes de réalisation décrits à titre exemplaire et non limitatif, de manière à former un autre mode de réalisation qui n'est pas nécessairement illustré ou décrit. Un tel mode de réalisation n'est évidemment pas exclu de l'invention.

Dans la présente invention, le procédé est en partie dédié au test de dispositifs électroniques. On entend par « dispositif électronique » un dispositif microélectronique ou optoélectronique. Selon une application particulière, le procédé permet de tester des diodes électroluminescentes (LED), en particulier des LEDs unitaires isolées les unes des autres, et notamment des smart LEDs. Une smart LED comprend typiquement au moins une partie émissive à base de LED ou µLED, et une partie de pilotage de la partie émissive, telle qu'une électronique de pilotage intégrée.

Les LEDs ou dispositifs microélectroniques ou optoélectroniques unitaires présentent typiquement des dimensions, en projection dans un plan de base xy, comprises entre 5 µm × 5 µm et 100 µm × 100 µm.

L'invention peut être mise en oeuvre plus largement pour différents dispositifs microélectroniques et optoélectroniques, voire pour des dispositifs ou microsystèmes électromécaniques MEMS. L'invention peut par exemple être mise en œuvre dans le cadre de dispositifs laser ou photovoltaïque.

Sauf mention explicite, il est précisé que, dans le cadre de la présente invention, la disposition relative d'une troisième couche intercalée entre une première couche et une deuxième couche, ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément.

Ainsi, les termes et locutions « prendre appui » et « couvrir » ou « recouvrir » ne signifient pas nécessairement « au contact de ».

Les étapes du procédé telles que revendiquées s'entendent au sens large et peuvent éventuellement être réalisées en plusieurs sous-étapes.

Dans la présente demande de brevet, les termes « diode électroluminescente », « LED » ou simplement « diode » sont employés en synonymes. Une « LED » peut également s'entendre d'une « micro-LED » ou d'une smart LED, le cas échéant.

Une portion ou un élément qualifié de « sacrificiel », signifie que cet élément est destiné à être « sacrifié », c'est-à-dire retiré lors d'une étape ultérieure de procédé. En particulier, dans le cadre de la présente invention, la portion sacrificielle est destinée à être retirée avant désolidarisation de la structure de test et du dispositif électronique, pour favoriser cette désolidarisation. La portion sacrificielle au sens de la présente invention n'est donc pas assimilable à une portion ou une couche qui serait retirée après désolidarisation, par exemple lors d'un simple nettoyage. Ainsi, une couche de faible adhérence utilisée pour un collage temporaire et qui est retirée après décollage n'est pas une portion sacrificielle au sens de la présente invention. La portion sacrificielle peut ainsi être vue comme une portion de détachement par gravure.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, une diode à base de GaN comprend typiquement du GaN et des alliages d'AIGaN ou d'InGaN.

Un repère, de préférence orthonormé, comprenant les axes x, y, z est représenté sur certaines figures annexées. Ce repère est applicable par extension aux autres figures d'une même planche de figures.

Dans la présente demande de brevet, on parlera préférentiellement d'épaisseur pour une couche et de hauteur pour une structure ou un dispositif. L'épaisseur est prise selon une direction normale au plan d'extension principal de la couche, et la hauteur est prise perpendiculairement au plan de base xy. Ainsi, une couche présente typiquement une épaisseur selon z, lorsqu'elle s'étend principalement le long d'un plan xy, et un élément en saillie, par exemple une tranchée d'isolation, présente une hauteur selon z. Les termes relatifs « sur », « sous », « sous-jacent » se réfèrent préférentiellement à des positions prises selon la direction z.

Les valeurs dimensionnelles s'entendent aux tolérances de fabrication et de mesure près.

Les termes « sensiblement », « environ », « de l'ordre de » signifient, lorsqu'ils se rapportent à une valeur, « à 10% près » de cette valeur ou, lorsqu'ils se rapportent à une orientation angulaire, « à 10° près » de cette orientation. Ainsi, une direction sensiblement normale à un plan signifie une direction présentant un angle de 90±10° par rapport au plan.

Un objet de l'invention est de tester, via une structure de test et de transfert, le fonctionnement d'un dispositif optoélectronique. Un objet de l'invention est également de transférer, via une structure de test et de transfert, un plot de contact électrique sur un dispositif optoélectronique.

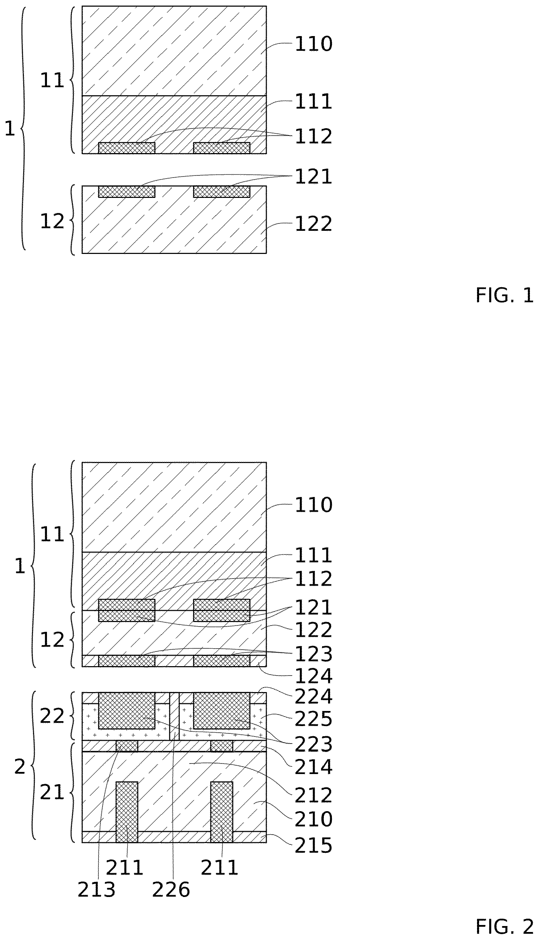

La figure 1 illustre un dispositif optoélectronique 1 de type smart LED. Ce dispositif 1 comprend ainsi typiquement au moins une partie émissive 11 à base de LED ou µLED, et une partie de pilotage 12 de la partie émissive 11.

La partie émissive 11 comprend notamment une région active 110 configurée pour émettre de la lumière selon une longueur d'onde principale, par exemple dans le bleu. La région active 110 est de préférence à base de GaN. Cette région active 110 peut être associée à un niveau de métallisation 111 comprenant des contacts 112 isolés entre eux par un matériau diélectrique, par exemple un oxyde de silicium.

La partie de pilotage 12 est typiquement configurée pour piloter la partie émissive 11. Elle peut ainsi comprendre une électronique de pilotage 122, comprenant typiquement des transistors basés sur la technologie CMOS, par exemple sous forme de microcircuits intégrés µIC. La partie de pilotage 12 peut également comprendre des contacts 121 prévus pour connecter électriquement cette partie de pilotage 12 à la partie émissive 11, via les contacts 112, 121. L'électronique de pilotage 122 est typiquement portée par un substrat semiconducteur qui peut être aminci, après connexion de la partie de pilotage 12 à la partie émissive 11, comme illustré à la figure 2.

Le dispositif 1 peut également comprendre, au niveau de la partie de pilotage 12, sur un côté opposé à la partie émissive 11, des zones de contact 123 isolées entre elles par une couche diélectrique 124. Ces zones de contact 123 permettent de connecter électriquement la partie de pilotage 12 à d'autres éléments, par exemple à des éléments de test ou de commande. Les zones de contact 123 et la couche diélectrique 124 forment ici une face de connexion 100.

Selon un exemple non illustré, le dispositif optoélectronique 1 comprend uniquement une partie émissive 11, sans partie de pilotage 12. C'est par exemple le cas d'une LED simple, sans électronique intégrée. Dans ce cas, la face de connexion 100 peut être formée par les contacts 112 et le matériau diélectrique du niveau de métallisation 111.

La face de connexion 100 est ici destinée à venir au contact d'une face de contact 200 d'une structure de test et de transfert 2.

Comme illustré à la figure 2, la structure de test et de transfert 2 comprend typiquement une partie de test 21 et une partie de contact 22.

La partie de test 21 comprend au moins un réseau d'interconnexions électriques 211, 213 configuré pour faire transiter un signal électrique de test en direction de la partie de contact 22. Dans l'exemple illustré à la figure 2, ce réseau d'interconnexions électriques 211, 213 est connecté à une électronique de test 212 comprenant typiquement des transistors basés sur la technologie CMOS, par exemple sous forme de microcircuits intégrés µIC. L'électronique de test 212 est ainsi intercalée entre des interconnexions électriques 211 et des interconnexions électriques 213 au contact de la partie de contact 22. Les interconnexions électriques 211 et/ou 213 sont typiquement formées au sein d'un support 210, par exemple en un matériau semi-conducteur tel que du silicium, portant l'électronique de test 212. L'électronique de test 212 peut être configurée pour communiquer avec un dispositif optoélectronique 1 de type smart LED, par exemple grâce à un protocole de communication dédié. Cette électronique de test 212 est cependant optionnelle. Les interconnexions 211, 213 peuvent être directement reliées à la partie de contact 22, sans interposer d'électronique de test 212. Les interconnexions 211 débouchent typiquement au niveau d'une face arrière 201 de la partie de test 21, de façon à permettre un accès électrique au niveau de cette face arrière 201. Les interconnexions 211 peuvent être isolées entre elles par une couche diélectrique 215, formant en partie la face arrière 201. Les interconnexions 213 peuvent être isolées entre elles par une couche diélectrique 214, formant en partie une interface avec la partie de contact 22.

La partie de contact 22 comprend au moins une portion sacrificielle 225 en un matériau électriquement conducteur, et au moins un plot de contact 223. Dans l'exemple illustré à la figure 2, la partie de contact 22 comprend deux portions sacrificielles 225 et deux plots de contact 223. Chaque partie sacrificielle 225 assure une continuité électrique entre un plot de contact 223 et une interconnexion 213 de la partie de test 21. Les signaux électriques de test délivrés par la partie de test 21, par exemple issus de l'électronique de test 212, parviennent ainsi aux plots de contact 223. Les portions sacrificielles 225 sont de préférence à base de silicium polycristallin dopé n++, noté polySi n++. Alternativement, elles peuvent être à base d'une colle conductrice. Dans l'exemple illustré, les portions sacrificielles 225 sont isolées entre elles par l'intermédiaire d'une tranchée d'isolation 226. Cette tranchée d'isolation 226 peut prendre appui sur la couche diélectrique 214 de la partie de test 21. Elle est typiquement à base d'oxyde de silicium SiO2. Les plots de contact 223 débouchent sur une face de contact 200. Dans l'exemple illustré, une couche diélectrique 224, également appelée couche de collage, isole en outre les portions sacrificielles 225 entre elles et les plots de contact 223 entre eux. La face de contact 200 est ici en partie formée par les plots de contact 223 et en partie formée par la couche diélectrique 224. La couche diélectrique 224 est destinée à venir au contact de la couche diélectrique 124 pour former un assemblage par collage moléculaire. Les plots de contact 223 sont destinés à venir au contact des zones de contact 123 pour assurer le test électrique du dispositif 1. Ces plots de contact 223 sont également destinés à rester sur ledit dispositif 1, typiquement après qu'un test électrique de ce dispositif 1 ait été effectué. Ils peuvent être assemblés aux zones de contact 123 par collage direct, par exemple par thermocompression ou par collage SAB. Comme détaillé dans la suite, les portions sacrificielles 225 permettent notamment de libérer plus facilement les plots de contact 223 en vue de leur transfert sur le dispositif 1.

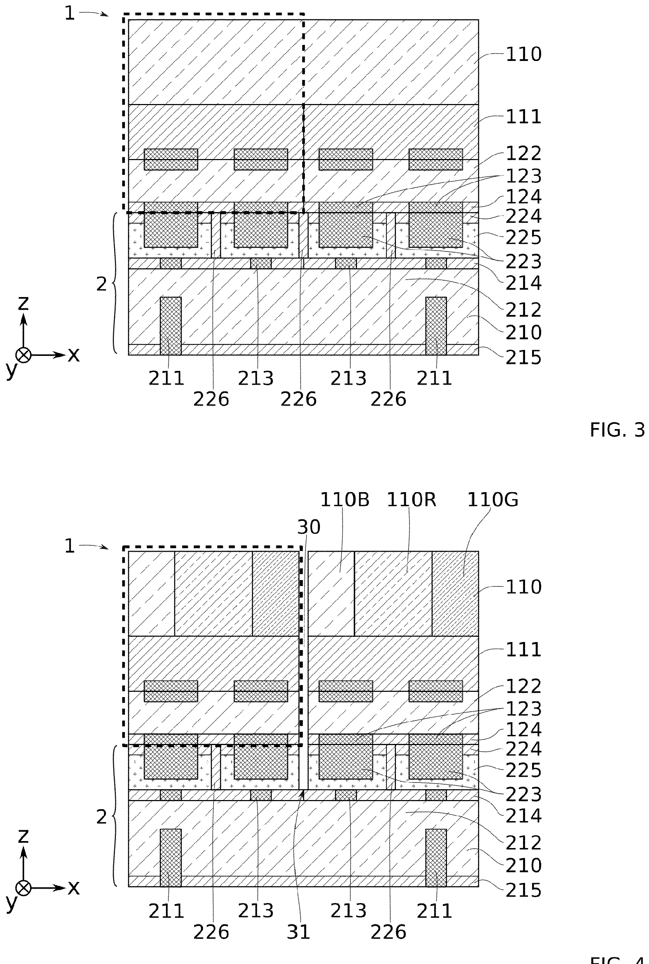

La figure 3 illustre une structure de test et de transfert 2 assemblée à deux dispositifs 1 comprenant chacun une région active 110, un niveau de métallisation 111, une électronique de pilotage 122 et deux zones de contact 123. La structure de test et de transfert 2 comprend ici des interconnexions 211, 213, une électronique de test 212, quatre portions sacrificielles 225 et quatre plots de contact 223. Les plots de contact 223 sont ici assemblés aux quatre zones de contact 123 des dispositifs 1. Des tranchées d'isolation 226 séparent les plots de contact 223 entre eux. Une étape de test peut être effectuée à ce stade, après assemblage de la structure de test et de transfert 2 aux dispositifs 1. Cette étape de test vise à déterminer quels sont les dispositifs 1 fonctionnels et des dispositifs 1 défectueux. Alternativement ou en combinaison, l'étape de test peut être effectuée après individualisation des dispositifs 1. Une cartographie des dispositifs 1 défectueux peut ainsi avantageusement être obtenue, avant ou après individualisation des dispositifs 1.

La figure 4 illustre une étape d'individualisation configurée pour séparer les dispositifs 1 entre eux par une tranchée de séparation 30. Dans cet exemple, les dispositifs optoélectroniques 1 comprennent chacun trois régions actives 110B, 110R, 110G, destinées à former typiquement trois sous-pixels d'un écran d'affichage. La tranchée de séparation 30 peut être effectuée de façon connue par gravure ionique anisotrope, ou par sciage par exemple. La formation de la tranchée de séparation 30 et de préférence configurée de façon à ce que le fond 31 de la tranchée 30 atteigne des portions sacrificielles 225. La tranchée de séparation 30 permet typiquement d'accéder aux portions sacrificielles 225. Cela permet ultérieurement de faciliter le retrait des portions sacrificielles 225.

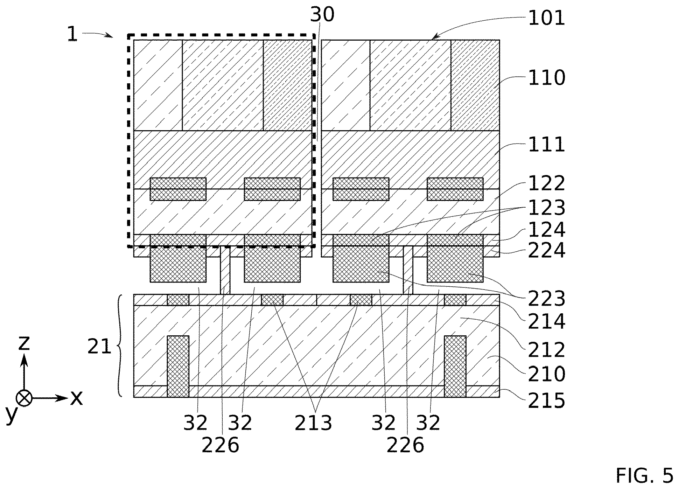

La figure 5 illustre une étape de retrait des portions sacrificielles 225. Cette étape permet de libérer en partie les plots de contact 223. Ces derniers ne sont ainsi plus directement au contact de la partie de test 21. Ils sont attachés aux zones de contact 123 des dispositifs 1. Cette étape de retrait peut se faire par gravure sélective du matériau des portions sacrificielles 225 vis-à-vis des matériaux environnants. Selon un exemple, les portions sacrificielles 225 sont à base de polySi n++ et le retrait se fait par gravure sèche à base de XeF2. Une telle gravure présente une bonne sélectivité vis-à-vis de l'oxyde de silicium des tranchées d'isolation 226 et des couches diélectriques 124, 224, 214 et vis-à-vis des matériaux métalliques des plots de contact 223. Selon une possibilité non illustrée, les bords de l'électronique de pilotage 122 exposés à cette gravure sèche sont protégés par une couche de protection à base de SiO2.

Après gravure, des cavités 32 sont alors formées autour des plots de contact 223. Les dispositifs optoélectroniques restent attachés à la partie de test 21 par l'intermédiaire des tranchées d'isolation 226. Un procédé de type « pick and place » permet dès lors de détacher facilement ces dispositifs 1 de la partie de test 21. Les tranchées d'isolation 226 forment un moyen d'attachement entre la partie de test 21 d'une part, et le dispositif optoélectronique muni des plots de contact 223. Les tranchées d'isolation 226 sont typiquement attachées indirectement aux plots de contact 223 par l'intermédiaire de la couche diélectrique 224, et directement au dispositif optoélectronique au niveau de la couche diélectrique 124. Les tranchées d'isolation 226 forment un moyen d'attachement complémentaire des portions sacrificielles 225, entre la partie de test 21 et les plots de contact 223 et/ou le dispositif optoélectronique.

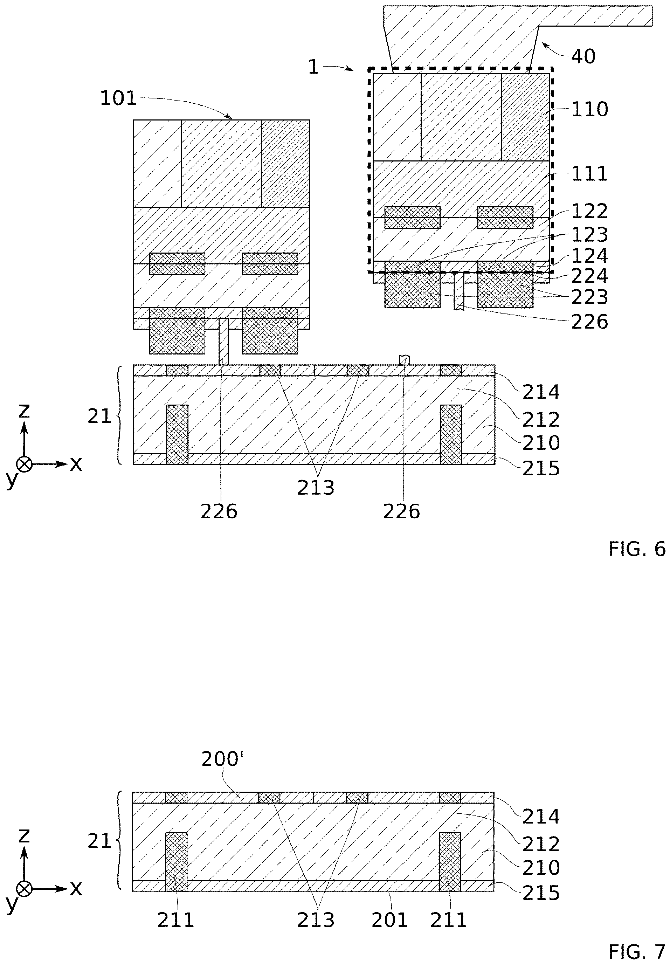

Comme illustré à la figure 6, un dispositif de transfert 40 peut être fixé à la face supérieure 101 des dispositifs. Une traction mécanique, par exemple selon z, peut alors être effectuée sur le dispositif 1 de façon à rompre la ou les tranchées d'isolation 226. Le dispositif 1 est alors détaché de la partie de test 21. Cette partie de test 21, qui peut comprendre une électronique de test coûteuse, peut-être avantageusement réutilisée pour des tests électriques ultérieurs.

Le dispositif de transfert 40 peut être commandé pour ne prélever que les dispositifs fonctionnels, en laissant les dispositifs défectueux sur la partie de test 21, qui sont ensuite éliminés.

Selon une possibilité, les dispositifs défectueux sont éliminés avant transfert des dispositifs fonctionnels, par exemple en les écrasant mécaniquement. L'écrasement des dispositifs défectueux peut se faire par une ou plusieurs aiguilles pilotées par des actuateurs, et positionnées au-dessus des dispositifs défectueux selon la cartographie obtenue à l'étape de test. Les aiguilles présentent typiquement une extrémité dont les dimensions sont inférieures à celles du dispositif défectueux à écraser. Cette extrémité n'est pas nécessairement pointue. L'écrasement peut se faire par pression de l'extrémité des aiguilles sur les dispositifs défectueux, de façon à rompre la ou les tranchées d'isolation 226. Une étape d'aspiration des dispositifs défectueux écrasés peut être prévue, avant prélèvement des dispositifs fonctionnels.

Le transfert des dispositifs fonctionnels peut alors être effectué de façon collective.

Les figures 7 à 12 illustrent un mode de réalisation d'une structure de test et de transfert telle que décrite dans les exemples précédents.

Comme illustré à la figure 7, la partie de test 21 peut se présenter sous forme d'un substrat semi-conducteur 210 portant une électronique de test 212, typiquement basée sur une technologie CMOS. Des interconnexions électriques 211, 213 peuvent être reliées à l'électronique de test 212. Ces interconnexions 211, 213 peuvent traverser de part en part la partie de test 21, en débouchant par exemple au niveau des faces avant 200' et arrière 201 de la partie de test 21. Les interconnexions 211 sont notamment destinées à être connectées par un module de test externe. Selon une possibilité non illustrée, la partie de test 21 présente un diamètre ou une dimension dans le plan xy plus grande que l'ensemble des dispositifs optoélectroniques à tester, et les interconnexions sont en partie situées sur les bords de la partie de test 21. En particulier, les interconnexions 211 peuvent être disposées en face avant 200'sur les bords de la partie de test 21. Cela permet de faciliter une connexion avec un module de test externe. Des couches diélectriques 214, 215 sont typiquement formées respectivement au niveau des faces avant 200' et arrière 201 autour des interconnexions 213, 211. Cela permet notamment d'isoler l'électronique de test 212 des perturbations extérieures et/ou des courts-circuits.

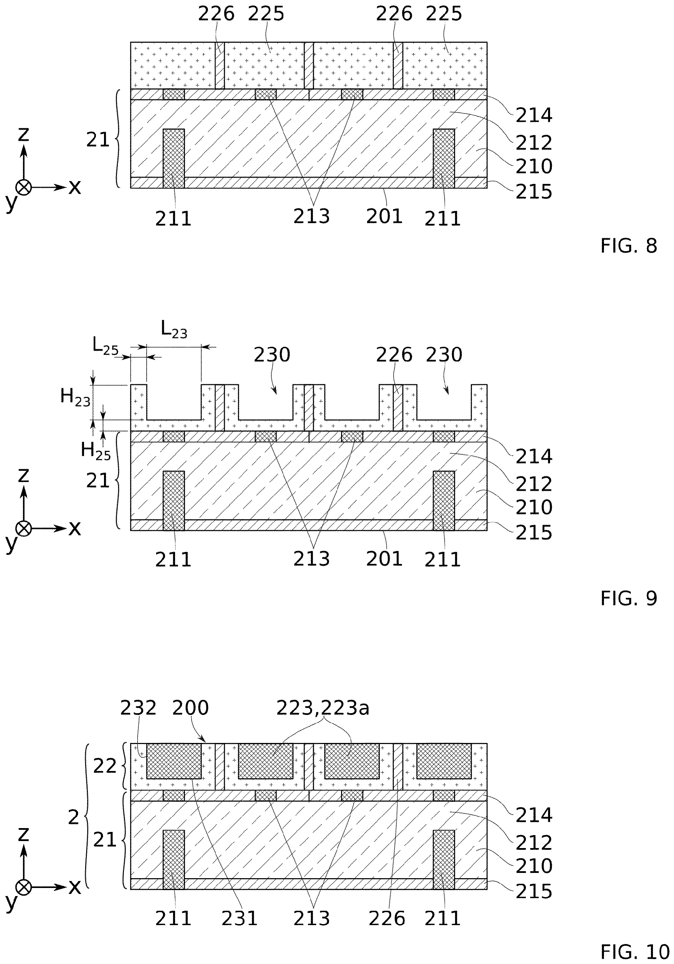

La figure 8 illustre la formation de portions sacrificielles 225 électriquement conductrices. Un dépôt d'une couche de polySi n++ est typiquement effectué sur la face avant 200' de la partie de test 21. Des tranchées sont ensuite gravées selon z dans cette couche de polySi n++, puis remplies par un matériau diélectrique, afin de former les tranchées d'isolation 226. Les tranchées d'isolation 226 présentent typiquement une continuité avec la couche diélectrique 214. Un caisson est ainsi en partie formé par les tranchées d'isolation 226, la couche diélectrique 214 et l'interconnexion 213 autour de chaque portion sacrificielle 225.

La figure 9 illustre la formation de cavités 230 destinées à accueillir les plots de contact 223. Chaque portion sacrificielle 225 est ainsi gravée sur une profondeur h23 et sur une largeur L23. Les portions sacrificielles 225 s'apparentent alors chacune à une boîte dont le fond présente une hauteur h25, et dont les flancs présentent une largeur L25. La dimension h23 peut être comprise entre 500 nm et 20 µm. La dimension L23 peut être comprise entre 5 µm et 50 µm. La dimension h25 peut être comprise entre 500 nm et 5 µm, de préférence entre 2 µm et 5 µm, encore plus préférentiellement entre 3 µm et 5 µm, de façon à faciliter la libération par gravure. La dimension L25 peut être comprise entre 200 nm et 20 µm. Les dimensions h23, h25 sont de préférence telles que 1 µm ≤ h23 + h25 ≤ 25 µm, et de préférence 5 µm ≤ h23 + h25 ≤ 15 µm.

La figure 10 illustre la formation des plots de contact 223, 223a au sein des cavités 230. Le remplissage des cavités 230 comprend typiquement d'abord la formation d'une couche d'or Au, puis la formation d'une couche de nickel Ni sur cette couche d'Au, puis la formation d'une couche de cuivre Cu sur cette couche de Ni. L'ordre de formation des couches métalliques du contact est ici inversé par rapport à un procédé de formation d'un contact métallique standard. Cela permet ensuite de reporter ce contact métallique directement sur un dispositif optoélectronique, sans retournement préalable.

Typiquement un dépôt d'or de faible épaisseur, par exemple de l'ordre de quelques dizaines à quelques centaines de nanomètres, est d'abord effectué sur le fond 231 des cavités. Ce dépôt d'or peut se faire par dépôt chimique en phase vapeur (CVD selon l'acronyme anglo-saxon) ou par dépôt physique en phase vapeur (PVD selon l'acronyme anglo-saxon), de façon à obtenir un germe d'or de bonne qualité cristalline. Le remplissage de la cavité peut ensuite se faire à partir de ce germe d'Au par dépôt électrochimique (ECD selon l'acronyme anglo-saxon) de façon à obtenir des épaisseurs de couches métalliques plus importantes.

Après remplissage, un polissage mécano-chimique (CMP selon l'acronyme anglo-saxon) est typiquement effectué de façon à obtenir une surface 200 plane. Une partie de contact 22 est ainsi formée sur la partie de test 21.

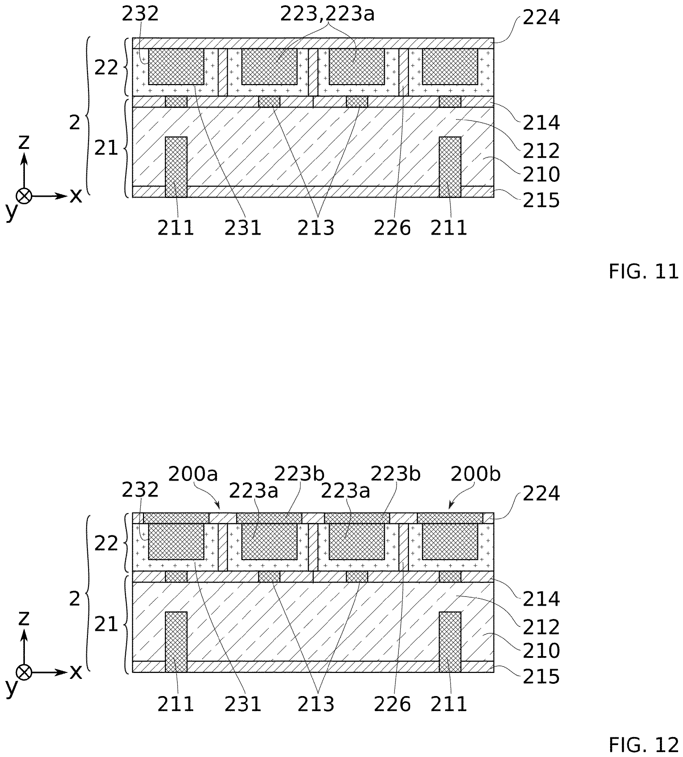

De façon optionnelle, comme illustré à la figure 11, une couche diélectrique 224 est formée au niveau de la face 200. Cette couche diélectrique 224 est ensuite ouverte par gravure au niveau des plots de contact 223a, comme illustré la figure 12. La couche diélectrique 224 est destinée à former en partie une couche de collage compatible avec le procédé de collage envisagé. Les ouvertures de cette couche de collage peuvent être plus nombreuses que les plots de contact 223a, notamment en fonction du procédé de collage et/ou de la dimension les plots de contact 223a. Une recharge métallique 223b est alors effectuée au niveau des contacts 223a, par exemple par dépôt d'un germe de cuivre suivi d'un dépôt électrochimique. Les contacts 223a et les recharges métalliques 223b forment les plots de contact 223. Les surfaces 200a des portions de couche diélectrique 224 forment avec les surfaces 200b des plots de contact 223 la face de contact 200 de la structure de test et de transfert 2. Un collage direct ou SAB peut avantageusement être effectué via les surfaces 200a. Un collage direct ou par thermocompression peut avantageusement être effectué via les surfaces 200b.

Comme illustré au travers des exemples précédents, les structure et procédé de test et de transfert selon l'invention permettent donc avantageusement de tester des dispositifs optoélectroniques unitaires et/ou de transférer des plots de contact sur ces dispositifs optoélectroniques unitaires.

L'invention n'est cependant pas limitée aux modes de réalisations précédemment décrits.

En particulier, le nombre, la forme et la disposition des interconnexions, des plots et des zones de contact peuvent être adaptés en fonction des dispositifs optoélectroniques à tester.

## Revendications

1. Structure (2) de test et de transfert de plots de contact (223) destinée à tester au moins un dispositif électronique (1) et à transférer au moins un plot de contact (223) sur ledit au moins un dispositif électronique (1), ladite structure (2) comprenant une partie de test (21), et une partie de contact (22), la partie de test (21) comprenant au moins un réseau d'interconnexions électriques (211, 213), la partie de contact (22) comprenant au moins un plot de contact (223) au niveau d'une face de contact (200), ledit au moins un plot de contact étant destiné à être mis en contact avec au moins une zone de contact (123) au niveau d'une face de connexion (100) du dispositif électronique (1), la structure étant **caractérisée en ce que** la partie de contact (22) comprend en outre au moins une portion (225) sacrificielle électriquement conductrice reliant électriquement l'au moins un plot de contact (223) au réseau d'interconnexions électriques (211, 213), ladite au moins une portion (225) sacrificielle étant apte à être gravée pour permettre de libérer l'au moins un plot de contact (223).

2. Structure selon la revendication précédente dans laquelle la partie de contact (22) comprend une couche (224) de collage au niveau de la face de contact (200), en bordure de l'au moins un plot de contact (223, 223b), de sorte que la face de contact (200) soit formée par une surface (200b) du plot de contact (223, 223b) et une surface (200a) de la couche (224) de collage.

3. Structure selon l'une quelconque des revendications précédentes dans laquelle l'au moins une portion (225) sacrificielle forme un premier moyen d'attachement direct entre l'au moins un plot de contact (223) et la partie de test (21), ladite structure comprenant en outre un deuxième moyen d'attachement (226) indirect entre l'au moins un plot de contact (223) et la partie de test (21), de sorte que, lorsque l'au moins une portion (225) sacrificielle est retirée sélectivement au deuxième moyen d'attachement (226), l'au moins un plot de contact (223) reste solidaire de la partie de test (21) par l'intermédiaire dudit deuxième moyen d'attachement (226).

4. Structure selon l'une quelconque des revendications précédentes dans laquelle l'au moins un plot de contact (223) comprend une première couche à base d'un matériau pris parmi Au, Sn, SnAg ou SnAgCu, de préférence une couche intercalaire de Ni, et une deuxième couche de Cu en empilement selon une direction (z) perpendiculaire à la face de contact (200), la deuxième couche de Cu étant située du côté de la face de contact (200), et la première couche étant située du côté opposé, en regard de la partie de test (21).

5. Structure selon l'une quelconque des revendications précédentes dans laquelle la portion (225) sacrificielle électriquement conductrice borde l'au moins un plot de contact (223) sur un côté (231) opposé à la face de contact (200) et en partie sur des flancs (232) latéraux de l'au moins un plot de contact (223).

6. Structure selon l'une quelconque des revendications précédentes dans laquelle la portion (225) sacrificielle électriquement conductrice est en silicium polycristallin dopé n++.

7. Structure selon l'une quelconque des revendications précédentes dans laquelle la partie de contact (22) comprend au moins une première portion (225) sacrificielle électriquement conductrice et une deuxième portion (225) sacrificielle électriquement conductrice, et au moins une tranchée d'isolation (226) à base de matériau diélectrique configurée pour isoler entre elles lesdites première et deuxième portions (225) sacrificielles électriquement conductrices.

8. Structure selon l'une quelconque des revendications précédentes dans laquelle la partie de test (21) comprend un circuit électronique intégré (212) relié au réseau d'interconnexions électriques (211, 213) et configuré pour communiquer avec le dispositif électronique (1).

9. Système comprenant une structure (2) de test et de transfert d'au moins un plot de contact (223) selon l'une quelconque des revendications précédentes, et une pluralité de dispositifs électroniques (1) présentant chacun une face de connexion (100) et comprenant chacun au moins une zone de contact (123), ladite structure (2) comprenant une pluralité de plots de contact (223), lesdits plots de contact (223) étant configurés pour être assemblés aux zones de contact (123) des dispositifs électroniques (1).

10. Système selon la revendication précédente dans lequel les dispositifs électroniques sont des diodes électroluminescentes ou des diodes électroluminescentes comprenant chacune une électronique de pilotage intégrée.

11. Procédé de test et de transfert d'au moins un plot de contact, destiné à tester au moins un dispositif électronique, et à transférer au moins un plot de contact depuis une structure (2) de test et de transfert selon l'une quelconque des revendications 1 à 8, sur ledit au moins un dispositif électronique, ledit procédé comprenant au moins les étapes suivantes :
• fournir l'au moins un dispositif électronique (1), ledit au moins un dispositif électronique présentant une face de connexion (100) comprenant au moins une zone de contact (123),
• aligner l'au moins un plot de contact (223) de la structure (2) de test avec l'au moins une zone de contact (123) du dispositif électronique,
• assembler la structure (2) de test au dispositif électronique (1),
• retirer l'au moins une portion (225) sacrificielle électriquement conductrice, sélectivement à l'au moins un plot de contact (223), puis
• désolidariser la structure de test du dispositif électronique, en laissant l'au moins un plot de contact (223) sur l'au moins une zone de contact (123) du dispositif électronique.

12. Procédé selon la revendication précédente comprenant en outre, après assemblage de la structure de test à l'au moins un dispositif électronique, et avant retrait de l'au moins une portion (225) sacrificielle électriquement conductrice, une étape de test du dispositif électronique prise parmi un test électrique ou un test de fonctionnement, ladite étape de test étant effectuée via la partie de test (21) de la structure (2).

13. Procédé selon l'une quelconque des revendications 11 à 12 dans lequel la portion (225) sacrificielle électriquement conductrice est à base de polySi n++ et le retrait est effectué par une solution de gravure à base de XeF2.

14. Procédé selon l'une quelconque des revendications 11 à 13 dans lequel l'au moins un dispositif électronique comprend un premier dispositif électronique et un deuxième dispositif électronique solidaires l'un de l'autre et comprenant des faces de connexion (100) dans un même plan, ledit procédé comprenant en outre, après assemblage de la structure de test auxdits premier et deuxième dispositifs électroniques, et avant retrait de l'au moins une portion (225) sacrificielle électriquement conductrice, une étape d'individualisation configurée pour séparer les premier et deuxième dispositifs électroniques par une tranchée de séparation débouchant dans l'au moins une portion (225) sacrificielle électriquement conductrice.

15. Procédé selon l'une quelconque des revendications 11 à 14 dans lequel la partie de contact (22) de la structure de test comprend au moins une première portion (225) sacrificielle électriquement conductrice et une deuxième portion (225) sacrificielle électriquement conductrice, et au moins une tranchée d'isolation (226) à base de matériau diélectrique configurée pour isoler entre elles lesdites première et deuxième portions (225) sacrificielles électriquement conductrices, ladite au moins une tranchée d'isolation maintenant l'au moins un dispositif électronique sur la structure de test après retrait desdites première et deuxième portions (225) sacrificielles électriquement conductrices,
et dans lequel la désolidarisation de l'au moins un dispositif électronique est effectuée en fixant un tampon sur une face (101) de l'au moins un dispositif électronique opposée à la face de connexion (100), et en exerçant une traction mécanique de sorte à rompre ladite au moins une tranchée d'isolation (226).

16. Procédé selon l'une quelconque des revendications 12 à 15, comprenant en outre, si l'au moins un dispositif électronique est repéré comme étant défectueux après l'étape de test, une étape d'élimination de ce dispositif défectueux, par exemple par écrasement après retrait de l'au moins une portion (225) sacrificielle électriquement conductrice.
